## Europäisches Patentamt
## European Patent Office
## Office européen des brevets

(19)

(11) Numéro de publication: **0 037 303**
**B1**

(12) # FASCICULE DE BREVET EUROPEEN

(45) Date de publication du fascicule du brevet:
**06.06.84**

(51) Int. Cl.³: **G 01 R 29/033**, G 01 S 7/52

(21) Numéro de dépôt: **81400396.8**

(22) Date de dépôt: **13.03.81**

---

(54) Circuit d'ébasage linéaire d'impulsions de tension avec condition de seuil réglable.

---

(30) Priorité: **28.03.80 FR 8007018**

(43) Date de publication de la demande:
**07.10.81 Bulletin 81/40**

(45) Mention de la délivrance du brevet:
**06.06.84 Bulletin 84/23**

(84) Etats contractants désignés:
**BE DE GB IT**

(56) Documents cités:
**FR - A - 1 296 633**
**US - A - 3 319 170**
**US - A - 3 573 820**
**US - A - 3 947 699**
**US - A - 3 963 983**

**IEEE TRANSACTIONS ON NUCLEAR SCIENCE, vol. NS-25, no. 1, février 1978, New York, US, BEDWELL et PAULUS: "A versatile constant fraction 100 MHz discriminator", pages 86-92**
**IEEE TRANSACTIONS ON NUCLEAR SCIENCE, vol. NS-18, no. 1, février 1971, New York, US, GOODMAN et al.: "A system for multiparameter pulse height analysis with repeated use of a single, fast ADC", pages 323-326**
**RAYTHEON, no., SP-1150, décembre 1967, QUINCY,**

(73) Titulaire: **HOTCHKISS-BRANDT SOGEME H.B.S.,
186, rue du Faubourg Saint-Honoré, F-75008 Paris (FR)**

(72) Inventeur: **Eder, André, THOMSON-CSF SCPI 173, Bld Haussmann, F-75360 Paris Cedex 08 (FR)**

(74) Mandataire: **Barbin le Bourhis, Joel et al, THOMSON-CSF SCPI 173, boulevard Haussmann, F-75379 Paris Cedex 08 (FR)**

(56) Documents cités: (suite)
**MASSACHUSETTS, US "Raysistor optoelectronic devices, circuit applications", pages 26-27**

---

**Description**

La présente invention concerne un circuit d'ébasage linéaire d'impulsions de tension avec conditions de seuil règlable. Elle trouve application dans tout traitement du signal quand il est nécessaire d'éliminer des impulsions parasites. L'invention est donc particulièrement avantageuse dans des ensembles d'exploitation de signaux impulsionnels provenant d'un système physique d'acquisition de données analogiques comme les échographes, sonars, radars, etc.

L'art antérieur présente des réalisations de tels circuits. Ceux-ci sont composés, très généralement, de semi conducteurs dont la polarisation est réglée de telle sorte que leur sortie ne transmet la valeur d'entrée qu'à partir d'un certain niveau de seuil dit niveau de rejection. Un inconvénient majeur de ces composants est leur non linéarité. Une conséquence de cet inconvénient est que, les rapports d'amplitude entre impulsions, que le circuit sélectionne, ne sont pas conservés. On connaît d'autre part un système permettant de restituer dans un signal toutes les parties d'amplitude supérieure à une valeur de seuil déterminée, ce système étant agencé de façon à comporter une ligne de transfert du signal analogique et une ligne de commande. Un tel système est décrit dans le brevet FR-A-- 1 296 633.

Pour remédier aux inconvénients mentionnés ci-dessus, la présente invention propose un circuit d'ébasage linéaire d'impulsions de tension avec condition de seuil règlable comportant, pour les signaux unipolaires, une entrée du signal analogique à traiter et une sortie du signal propre après traitement et deux lignes interconnectées, la première ligne ou ligne de transfert du signal analogique comportant un atténuateur à transfert commandable et la seconde ligne ou ligne de commande, connectée entre ladite entrée du signal et une entrée de commande dudit atténuateur, comportant un générateur de condition de seuil réglable par un premier circuit de réglage, ledit générateur de condition de seuil étant en série avec un générateur de commande de l'atténuateur ce générateur de commande étant relié à ladite entrée de commande de l'atténuateur, caractérisé en ce que ladite ligne de transfert comporte en outre l'entrée du signal analogique à traiter et l'attenvateur une ligne à retard associée à un deuxième circuit de réglage pour régler ledit retard, en ce que ledit générateur de commande est constitué par un monostable associé à un circuit de temporisation réglable qui permet une remise à zéro temporisée dudit monostable et en ce qu'un circuit de déblocage dudit circuit de temporisation est relié entre la sortie dudit générateur de condition de seuil et ledit circuit de temporisation.

La présente invention se réfère aussi à un circuit d'ébasage peur des signaux bipolaires comme proposé dans la revendication 7.

La présente invention sera mieux comprise à l'aide de la description et des dessins annexés qui sont:

la fig. 1: un schéma bloc de circuit selon l'invention;

la fig. 2: une variante d'un détail de la fig. 1;

la fig. 3: une variante d'un détail de la fig. 1;

la fig. 4: un schéma du générateur de commande de l'atténuateur;

la fig. 5: un détail de la fig. 4;

la fig. 6: un diagramme de quatre tensions caractéristiques;

la fig. 7: un schéma de circuit à deux voies.

Dans la première partie de ce qui suit, la description est limitée à des signaux en impulsions positives. Il est entendu que les mêmes éléments sont applicables pour des signaux en impulsions négatives. La seconde partie comporte une description d'un circuit selon l'invention pour signaux bipolaires. Enfin, on trouvera une description de diverses applications comportant des indications selon les bandes de fréquence envisagées.

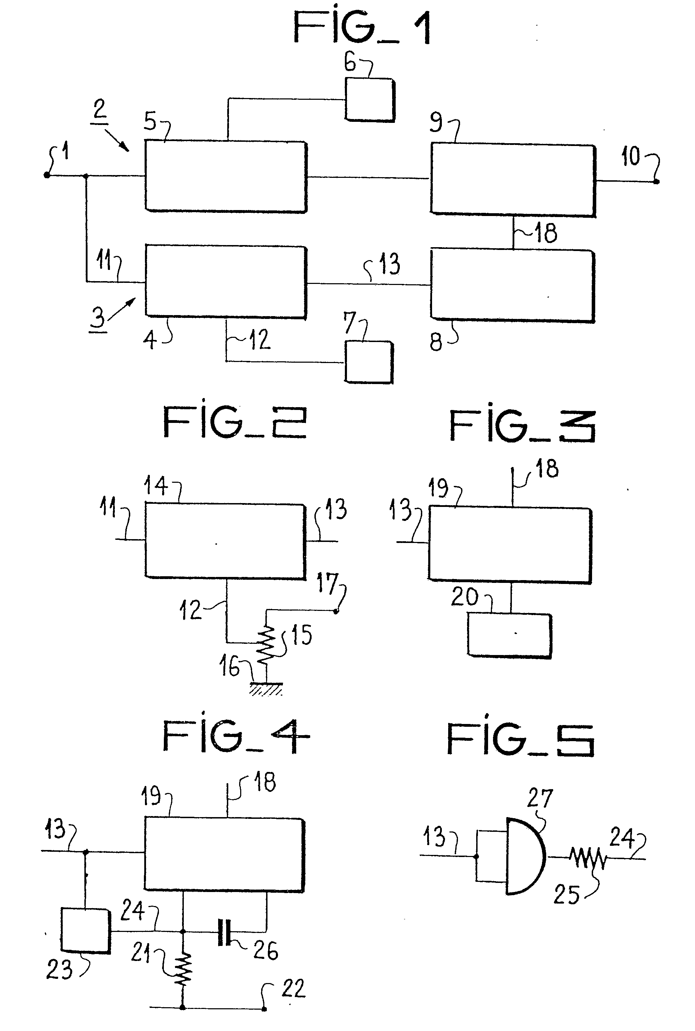

La fig. 1 représente un schéma bloc d'un circuit selon l'invention. Ce circuit comporte une entrée (1) et une sortie (10), les deux lignes sont: la ligne (2) de transfert du signal analogique et la ligne (3) de commande. La ligne (2) de transfert du signal analogique comporte en série la ligne à retard (5) et son circuit de réglage de retard (6), en série avec l'atténuateur (9). La ligne (3) de commande comporte le générateur (4) de condition de seuil avec son circuit de réglage (7) en série avec le générateur (8) de commande de l'atténuateur.

La fig. 2 représente un générateur (4) de condition de seuil avec son circuit de seuil (7). Ils sont constitués par un montage comparateur (14) comportant une ligne d'entrée de la tension à comparer (11), une ligne d'entrée (12) de la tension de seuil de comparaison et une ligne de sortie (13). Cette dernière est activée quand la tension à comparer est supérieure ou égale à la tension de seuil de comparaison fournie par le potentiomètre (15) placé entre la masse (16) et l'alimentation continue (17).

La fig. 3 représente le générateur (8) de commande de l'atténuateur (9). Il comporte un monostable (19) et un circuit (20) de commande et de réglage de sa temporisation.

La fig. 4 représente un mode particulier de circuit de commande et de réglage (20) de la temporisation du monostable (19). Un tel circuit (20) comporte le condensateur (26) réglable ou ajustable, extérieur au monostable, la résistance (21) de réglage de la constante de temps du monostable et un circuit (23) de mise en forme de l'ordre de débloquage de la temporisation.

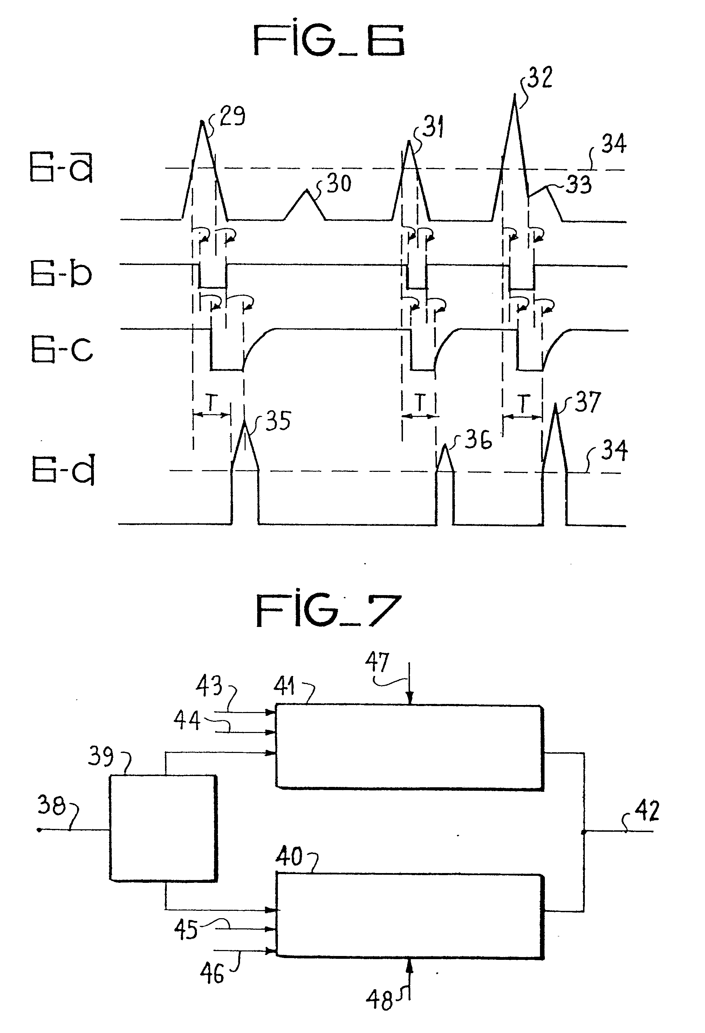

La fig. 5 montre un exemple particulier d'un tel circuit (23). Il comporte une porte »ET« (27) du type dit à collecteur ouvert qui à l'état logique haut débite à travers la résistance (25) dans la ligne (24).

Un échographe comportant un tel circuit est classiquement composé d'une sonde fonctionnant en émission-réception, d'une électronique de contrôle pour réaliser par exemple une focalisation dynamique et d'un ensemble de traitement pour réaliser une image ultrasonore. Le circuit selon l'invention s'insère dans la chaîne, entre la sonde et l'ensemble de traitement des signaux électro-acoustiques pour visualisation.

La fig. 6, qui comprend les diagrammes 6-a à 6-d permet de matérialiser le fonctionnement de la chaîne.

Après remise en forme électrique, les échos ultrasonores, par la sonde, donnent des impulsions de tension noyées dans un bruit provenant de diverses origines. Parmi les impulsions de tension recueillies, représentées schématiquement à la fig. 6, au diagramme 6-a, se trouvent des échos parasites (30, 33). Leurs origines peuvent être diverses. Ils peuvent provenir de réflexions sur des joints de grains en métallurgie, sur des inhomogénéités de tissus en examen médical, etc. Leur amplitude est souvent réduite, relativement aux impulsions propres, spécifiques des structures à visualiser. Mais elle est aussi supérieure au niveau de bruit et devient détectable par les moyens de visualisation.

Leur position dans le temps peut prendre deux dispositions principales, représentées au diagramme 6-a. L'impulsion propre (29) peut être suivie d'une impulsions parasite (30). Mais une impulsion propre comme (32) peut aussi contenir dans son front de descente un écho parasite (33).

Quand un tel signal est présenté à l'entrée (1) du circuit selon l'invention, il est transmis sur la ligne 2 de transfert du signal à l'entrée de l'atténuateur 9 avec un retard de temps engendré par la ligne à retard. Ce retard permet de compenser les temps de montée des éléments de la ligne 3 de commande.

Dans l'exemple de réalisation préférée, l'atténuateur 9 est avantageusement constitué par un interrupteur analogique par exemple du type MOS-FET. Son entrée est connectée à la sortie de la ligne à retard 5 et sa sortie à la sortie 10 du circuit selon l'invention. Sa gâchette de commande est reliée à la ligne 3 de commande.

Celle-ci reçoit aussi le signal tel que 6a. Le générateur 4 du signal de commande, monté en comparateur 14 reçoit par son entrée »tension de référence« 12 une tension de seuil de référence du potentiomètre 17. Cette tension est une tension continue 34 sur le diagramme 6-a. Cette tension est le niveau de réjection des tensions par la base, c'est-à-dire qu'elle situe le niveau d'ébasage des impulsions. Par son entrée »tension d'entrée« 11, le comparateur 14 reçoit le signal lui-même. La condition de sortie est que, la ligne de sortie 13 du comparateur 14 devient active quand la tension d'entrée est supérieure à la tension de seuil 34. Pour un signal et une tension de seuil 34 comme dans le cas du diagramme 6-a, l'état de sortie du comparateur est de la forme du diagramme 6-b. D'après le niveau de réjection engendré par la tension de seuil 34, les impulsions parasites 30, 33 ne font pas déclencher le comparateur 14. Seules, les impulsions propres 29, 31, 32 donnent lieu à des impulsions dont la durée correspond au temps pendant lequel la tension de l'impulsion propre est supérieure à la tension de seuil 34.

Il est à remarquer que la forme du diagramme 6-b doit être inversée si le comparateur travaille en logique positive.

Le diagramme 6-c représente la réponse du générateur de commande (8) de l'atténuateur (9) quand il est constitué par un montage à monostable comme aux fig. 3, 4 et 5. En l'absence de toute excitation à son entrée 13, le monostable reste inactif. Dès qu'on lui applique un signal à l'entrée 13, le monostable est temporisé. Mais, la porte »ET« 27, bloque la temporisation par mise à la tension d'alimentation 22. Quand le signal d'entrée remonte la porte »ET« 27, bascule et la temporisation secondaire du monostable 19 est déclenchée. Cette temporisation secondaire a été représentée par la partie exponentielle de chaque créneau de temporisation. La constante de temps de cette temporisation est proportionnelle à la valeur du condensateur 26. Cette valeur peut être ajustable pour régler la forme de la temporisation.

Le rôle de la temporisation secondaire dans le comportement du circuit est de permettre de supprimer des instabilités dûes à une commutation trop rapide. Elle peut correspondre, dans le cas d'un contrôle non destructif de pièces à une filtration équivalente à 0,6 mm d'acier.

Le diagramme 6-d correspond au signal de sortie (10) du circuit ébaseur. Les impulsions propres traitées ont été décalées d'un retard T volontairement grossi sur le dessin. Le retard T, identique pour toutes les impulsions d'un même signal est réglable sur la ligne à retard 5 par l'intermédiaire du circuit 6. Il correspond à la somme des temps de réponse des différents composants de la ligne 3 qu'il permet de rattraper. Les temps de réponse sont représentés à la fig. 6 par les décrochements des fronts de déclenchement repérés par des flèches.

La temporisation secondaire sur le monostable 19, intervient quand la tension d'entrée 1 retombe sous la tension de seuil 34. A ce moment, le signal de sortie, retardé d'une durée T par la ligne à retard 5, est coupé progressivement par l'interrupteur commandé 9. On évite ainsi les perturbations et oscillations de relaxation.

Les impulsions 35, 36 et 37 sont dites ébasées. L'ensemble du signal d'entrée a de plus été séparé de son bruit par la réjection de niveau 34. Seul le bruit induit par le circuit va entrer en ligne de compte ainsi que le bruit résiduel non filtré par lui.

Dans diverses applications, les signaux à exploiter sont bipolaires. Pour réaliser un ébasage selon l'invention, on a représenté à la fig. 7 un circuit bipolaire. Il comporte une entrée 38 et une sortie 42 bipolaire. Le signal bipolaire d'entrée est séparé en deux signaux positif ou négatif par un discriminateur 39 de polarité. Le discriminateur 39 comporte deux sorties, la première attaquant un circuit ébaseur monopolaire dit circuit de voie positive 40 et la seconde un circuit similaire, dit de voie négative 41. Ces deux circuits 40
et 41 sont analogues au circuit décrit à la fig. 1.
Els peuvent comporter à leurs sorties respectives
des systèmes anti-retour, par exemple des
diodes convenablement polarisées.

Les dites sorties sont alors connectées à la
sortie 42 du circuit bipolaire. Ce dernier peut
comporter 6 entrées de réglage indépendantes:

— deux entrées de réglage de tension de seuil
   43 et 45 l'entrée 43 réservée à la voie négative, l'entrée 45 réservée à la voie positive;
— deux entrées de réglage des retards 44 et 46
   l'entrée 44 réservée à la voie négative, l'entrée 46 réservée à la voie positive;
— deux entrées de réglage des temporisations
   secondaires 47 et 48 l'entrée 47 réservée à la
   voie négative, l'entrée 48 réservée à la voie
   positive.

Il peut exister un ensemble permettant de lier
ces 6 grandeurs entre elles en fonction de décisions préprogrammées par exemple. Elles n'ont
pas été présentées ici.

En échoscopie, la bande de fréquence occupée par les impulsions propres s'étend de 0 à
15 Mhz. La ligne à retard 5 doit couvrir la bande
occupée. Dans le cas d'un retard nécessaire faible (de 50 à 100 ns), il est possible de remplacer
la ligne à retard par la mise en cascade de plusieurs amplificateurs. L'interrupteur 9 sera avantageusement un transistor FET ou MOS. Le générateur 19 de commande de l'interrupteur sera
alors constitué par une simple porte logique qui
ne commutera qu'à partir de la valeur de réjection.

Dans le cas d'une application à des domaines
VHF, la technoligie sera une technologie microélectrique à bases d'anneaux hybrides par exemple ou encore une technologie en ondes forcées
avec guides d'ondes et tubes TR et ATR. Les
perturbations dûes aux commutations pourront
être corrigées par une variation définie de la
commande d'affaiblissement de l'atténuateur 9.

D'une façon plus générale, il est possible
d'appliquer l'invention à un dispositif de mémorisation des amplitudes des signaux et de l'inclure dans un ensemble de régulation de niveau,
par exemple. La commande est alors réalisée au
niveau du retard de temps de la ligne à retard 5.

En effet pour mémoriser l'amplitude crête de
l'impulsion propre, il convient de faire coïncider
la retombée en état inactif de la commande du
monostable 18 avec l'arrivée à la crête de l'impulsion propre sur l'interrupteur 19. La temporisation secondaire du monostable 18 permet un
réglage de mise en phase du signal mémorisé.
Pour cela, on dispose du circuit 6 de réglage de
retard T de la ligne à retard 15 et du circuit 7 de
réglage de la constante de temps de la temporisation secondaire du monostable 18.

Le circuit selon l'invention peut être adapté à
une troisième application. En effet, la bande de
fréquence occupée par les signaux propres est largement plus réduite que la bande de fréquence occupée par d'éventuels signaux parasites. Par exemple, dans le cas d'une bande de
signal propre de 0 à 6 Mhz, les parasites occupent une bande allant au moins jusqu'à 30 Mhz
dans le cas de l'échoscopie. Il convient alors de
choisir des composants (ligne à retard 5, atténuateur 9, comparateur 4, etc) qui soient linéaires (aux spécifications près) sur la bande occupée, soit de 0 à 6 Mhz. Les signaux parasites
au voisinage de 30 Mhz, sont transmis par les
composants du circuit dans leur partie non linéaire. Comme leur amplitude est plus faible que
celle du signal propre, ils seront considérablement affaiblis par les caractéristiques non linéaires des composants à 30 Mhz.

Pour certaines formes d'impulsions propres, il
peut être nécessaire de placer un filtre RC passe
bas à l'entrée double de la porte ET »27«, sur la
ligne 13 à la fig. 5. Un tel circuit permet alors de
filtrer des oscillations dues à la sortie du générateur (4) du signal de commande.

## Revendications

1. Circuit d'ébasage linéaire d'impulsions de
tension avec condition de seuil règlable comportant, pour des signaux unipolaires, une entrée (1)
du signal analogique à traiter et une sortie (10)
du signal propre après traitement et deux lignes
interconnectées, la première ligne (2) ou ligne de
transfert du signal analogique comportant un atténuateur (9) à transfert commandable et la seconde ligne (3) ou ligne de commande, connectée entre ladite entrée du signal et une entrée
(18) de commande dudit atténuateur, comportant un générateur (4) de condition de seuil réglable par un premier circuit de réglage (7), ledit
générateur de condition de seuil étant en série
avec un générateur (8) de commande de l'atténuateur, ce générateur de commande étant relié
à ladite entrée de commande de l'atténuateur,
caractérisé en ce que ladite ligne de transfert
comporte en outre entre l'entrée du signal analogique à traiter et l'atténuateur une ligne (5) à
retard (T) associée à un deuxième circuit de réglage (6) pour régler ledit retard (T), en ce que
ledit générateur de commande (8) est constitué
par un monostable (19) associé à un circuit de
temporisation réglable (20) qui permet une remise à zéro temporisée dudit monostable et en
ce qu'un circuit de déblocage (23) dudit circuit
de temporisation est relié entre la sortie (13) dudit générateur de condition de seuil et ledit circuit de temporisation.

2. Circuit selon la revendication 1, caractérisé
en ce que l'atténuateur (9) est un interrupteur
analogique pour les applications basse fréquence.

3. Circuit selon la revendication 2, caractérisé
en ce que le générateur de condition de seuil (4)
comporte un comparateur (14) de tension d'entrée (11) à une tension de référence règlable par
le premier circuit de réglage (7).

4. Circuit selon la revendication 3, caractérisé en ce que le premier circuit de réglage (7) comporte un potentiomètre (15) connecté entre la masse (16) et l'alimentation continue (17) du circuit.

5. Circuit selon l'une des revendications précédentes, caractérisé en ce que ledit circuit de temporisation comporte, un condensateur (26) et une résistance (21) alimentés par une tension continue et en ce que ledit circuit de déblocage est connecté au point commun dudit condensateur et de ladite résistance.

6. Circuit selon l'ensemble des revendications 3 et 5, caractérisé en ce que le circuit de déblocage (23) de la temporisation du monostable (13) comporte une porte (27) de type »ET«, montée en collecteur ouvert, dont les entrées communes sont connectées à la sortie (13) du comparateur (14).

7. Circuit d'ébasage comportant une entrée (38) pour des signaux bipolaires et faisant application du circuit selon l'une des revendications précédentes pour des signaux unipolaires, caractérisé en ce que l'entrée des signaux bipolaires est reliée à un discriminateur de polarité (39) comportant deux sorties donnant chacune un signal unipolaire; chacune de ces deux sorties étant reliée à un circuit d'ébasage pour signaux unipolaires (40, 41) selon l'une des revendications précédentes et fonctionnant dans une polarité donnée.

**Patentansprüche**

1. Lineare Impuls-Kleinstwert-Begrenzungsschaltung mit einstellbarem Schwellwert, für Signale mit nur einer Polarität, mit einem Eingang (1) für das zu verarbeitende Analogsignal und einen Ausgang (10) des nach Verarbeitung bereinigten Signals sowie zwei miteinander verbundenen Leitungen, von denen die erste (2) bzw. die Übertragungsleitung für das Analogsignal ein Dämpfungsglied (9) mit steuerbarer Durchschaltung und die zweite Leitung (3) bzw. Steuerleitung, welche zwischen den Signaleingang und einen Steuereingang (18) des Dämpfungsgliedes geschaltet ist, einen Schwellwertgenerator (4) umfaßt, der durch eine erste Einstellschaltung (7) einstellbar ist, wobei der Schwellwertgenerator in Reihe mit einem Generator (8) zur Steuerung des Dämpfungsgliedes liegt und wobei dieser Steuergenerator mit dem Steuereingang des Dämpfungsgliedes verbunden ist, dadurch gekennzeichnet, daß die Übertragungsleitung ferner zwischen dem Eingang für das zu verarbeitende Analogsignal und dem Dämpfungsglied eine verzögernde (T) Leitung (5) umfaßt, der eine zweite Einstellschaltung (6) zum Einstellen der Verzögerung (T) zugeordnet ist, daß der Steuergenerator (8) durch ein monostabiles Element (19) gebildet ist, dem eine einstellbare Zeitgeberschaltung (20) zugeordnet ist, welche die verzögerte Nullrücksetzung des monostabilen Elements ermöglicht, und daß eine Freigabeschaltung (23) zur Freigabe der Zeitgeberschaltung zwischen den Ausgang (13) des Schwellwertgenerators und die Zeitgeberschaltung eingefügt ist.

2. Schaltung nach Anspruch 1, dadurch gekennzeichnet, daß das Dämpfungsglied (9) ein Analogschalter für Niederfrequenzanwendungen ist.

3. Schaltung nach Anspruch 2, dadurch gekennzeichnet, daß der Schwellwertgenerator (4) einen Komparator (14) zum Vergleichen der Spannung am Eingang (11) mit einer Referenzspannung umfaßt, die durch die erste Einstellschaltung (7) einstellbar ist.

4. Schaltung nach Anspruch 3, dadurch gekennzeichnet, daß die erste Einstellschaltung (7) ein Potentiometer (15) umfaßt, das zwischen Masse (16) und die Gleichstromversorgung (17) der Schaltung eingefügt ist.

5. Schaltung nach einem der vorstehenden Ansprüche, dadurch gekennzeichnet, daß die Zeitgeberschaltung einen Kondensator (26) und einen Widerstand (21) enthält, die durch eine Gleichspannung gespeist sind, und daß die Freigabeschaltung mit dem Verbindungspunkt zwischen Kondensator und Widerstand verbunden ist.

6. Schaltung nach Anspruch 3 in Verbindung mit Anspruch 5, dadurch gekennzeichnet, daß die Freigabeschaltung (23) für die Zeitsteuerung des monostabilen Elements (13) eine Torschaltung (27) vom AND-Typ enthält, die in offener Kollektorschaltung ausgeführt ist und deren gemeinsame Eingänge mit dem Ausgang (13) des Komparators (14) verbunden sind.

7. Kleinstwert-Begrenzungsschaltung mit einem Eingang (38) für Signale beider Polaritäten, unter Anwendung der Schaltung nach einem der vorstehenden Ansprüche für Signale mit einer einzigen Polarität, dadurch gekennzeichnet, daß der Eingang für die Signale beider Polaritäten mit einem Polaritätsdiskriminator (39) verbunden ist, welcher zwei Ausgänge aufweist, von denen jeder ein Signal mit einer einzigen Polarität abgibt; wobei jeder dieser beiden Ausgänge mit einer Kleinstwert-Begrenzungsschaltung für Signale einer einzigen Polarität (40, 41) nach einem der vorstehenden Ansprüche verbunden ist, die mit einer gegebenen Polarität arbeitet.

**Claims**

1. Linear pulse pedestal clipping circuit having an adjustable threshold comprising for signals of single polarity an input (1) for the analog signal to be processed and an output (10) of the corrected signal after processing and two interconnected lines, the first (2) or transfer line for the analog signal comprising an attenuator (9) with controllable transfer and the second line (3) or control line connected between said signal input and a control input (18) of the attenuator, a threshold generator (4) adjustable by a first adjusting circuit (7), said threshold generator being in series with a generator (8) for controlling the attenuator, said control generator being connected to said control input of the attenuator, characterized in that said transfer line further comprises between the input for the analog signal to be processed and the attenuator a delay (T) line (5) associated with a second adjusting circuit (6) for adjusting the delay (T), that said control generator (8) is formed by a monostable component (19) associated with an adjustable timing circuit (20) which permits delayed resetting to zero of the monostable component, and that an enabling circuit (23) for enabling said timing circuit is connected between the output (13) of said threshold generator and said timing circuit.

2. Circuit according to claim 1, characterized in that the attenuator (9) is an analog switch for lowfrequency applications.

3. Circuit according to claim 2, characterized in that the threshold generator (4) comprises a comparator (14) for comparing the voltage at the input (11) with a reference voltage adjustable by the first adjusting circuit (7).

4. Circuit according to claim 3, characterized in that the first adjusting circuit (7) comprises a potentiometer (15) connected between the ground (16) and the direct-current supply (17) of the circuit.

5. Circuit according to one of the preceding claims, characterized in that said timing circuit comprises a capacitor (26) and a resistor (21) fed by a DC voltage and that the enabling circuit is connected to the common point between said capacitor and said resistor.

6. Circuit according to the combination of claims 3 and 5, characterized in that the enabling circuit (23) for the time control of the monostable component (13) comprises a gate (27) of the AND type in open collector connection, the common inputs of which are connected to the output (13) of the comparator (14).

7. Pedestal clipping circuit having an input (38) for signals of both polarities and employing the circuit according to one of the preceding claims for signals of single polarity, characterized in that the input for the signals of both polarities is connected to a polarity discriminator (39) having two outputs, each emitting a signal of single polarity; each of said two outputs is connected to a pedestal clipping circuit for signals of a single polarity (40, 41) according to one of the preceding claims and operating with a given polarity.

0 037 303

# FIG_1

# FIG_2

# FIG_3

# FIG_4

# FIG_5

# FIG_6

# FIG_7